# EUROPEAN PATENT APPLICATION

(11) **EP 2 560 112 A2**
(43) Date of publication of application: **20.02.2013**
(21) Application number: 12179109.9
(22) Date of filing: 02.08.2012
(51) Int. Cl.: G06F 17/50, G06T 17/00

(54) **Method, apparatus and computer program product for simplifying a representation of a computer-aided design model**

(30) Priority: 15.08.2011 US 201113210054
(71) Applicant: Honeywell International Inc., Morristown, NJ 07962-2245 (US)
(72) Inventor: Tayal, Praveen, Morristown, NJ New Jersey 07962-2245 (US); Gattu, Raghavendra, Morristown, NJ New Jersey 07962-2245 (US); Agarwal, Vikas Kumar, Morristown, NJ New Jersey 07962-2245 (US); Mankowski, Eryk, Morristown, NJ New Jersey 07962-2245 (US)
(74) Representative: Houghton, Mark Phillip

(57) **Abstract**

A method for simplifying a representation of a computer-aided design model may include determining cavities within a three-dimensional computer-aided drawing model and closing the cavities (120, 130) with a closing feature (122,132) where the closing feature (122,132) is disposed at a predefined depth below the cavity opening. Determining cavities (120, 130) may include calculating the number of cavities within the model. Calculating the number of cavities (120, 130) within the model may include checking the number of internal loops present on the model. The method may further include generating a surface extract including an outer skin of the model, closing the outer skin, and filling the skin to create a filled solid body. The method may still further include generating a set of two-dimensional views of the model, each two-dimensional view from a respective viewpoint, where the set of viewpoints encircles the three-dimensional model.

## Description

### TECHNOLOGICAL FIELD

Embodiments of the present invention relate generally to solutions for providing a simplified representation of a computer-aided design (CAD) model, and, more particularly, to a mechanism for providing a less detailed representation of a CAD model for use in operations that do not require the highest level of detail, such as packaging design or arrangement of the CAD model assembly in a system, for example, a turbocharger as arranged with an engine intake and exhaust.

### BACKGROUND

Computer-aided design (CAD) models of complex parts and assemblies can be extraordinarily detailed including finite details of even the smallest components within an assembly. Individual components of a CAD model may include detailed surface profiles, internal parts, or complex surfaces such as a helical thread pattern. Large assemblies with numerous components may cause the file size of the CAD model to be dozens of megabytes and cause the CAD software program to consume vast amounts of memory when opening, manipulating, or rendering the CAD file. However, some operations or uses for the CAD model may not require the highest level of detail available in the original version of the CAD file. Further, detailed CAD models may contain components or sub-assemblies with proprietary information or details that would be undesirable to share with external customers and suppliers. Accordingly, a simplified CAD file may be desirable for operations in which the highest level of detail is not required.

The process for creating a simplified rendering of a CAD model may include a number of operations, each of which may require significant manual manipulation by a user. For example, openings and orifices in a CAD model may be closed with the provision of the opening profile remaining visible up to certain depth such that a customer or supplier can design fittings or fasteners for the openings or orifices. The internal cavities of a product, such as a turbocharger, may be filled in order to mask internal gas-flow and oil-flow details which may be proprietary in nature. The internal components of an assembly which are not externally visible may be removed from the CAD model. The individual components of the CAD model may be merged into a single component or grouped into multiple larger components based upon customer or supplier needs. Each of these operations may require a user to individually select features and delete or modify them as necessary such that the process may be time consuming and tedious in addition to introducing many opportunities for errors. It may be desirable to develop a method to create a simplified rendering of a CAD model without requiring minimal user input at each step of the process.

### BRIEF SUMMARY

A method, apparatus and computer program product are therefore provided to simplify a representation of a computer-aided design model. For example, some embodiments may provide a mechanism by which a three-dimensional computer-aided design model with a high level of detail is simplified to a representation of the computer-aided design model with a lower level of detail. Accordingly, efficient transfer of only relevant and necessary detail information may be provided to a supplier, customer, or other entity.

In one example embodiment, a method for providing a simplified representation of a computer-aided design model is provided. The method may include determining cavities within a three-dimensional computer-aided drawing model and closing the cavities with a closing feature where the closing feature is disposed at a pre-defined depth below the cavity opening. Determining cavities may include calculating the number of cavities within the model. Calculating the number of cavities within the model may include checking the number of internal loops present on the model. The method may further include generating a surface extract including an outer skin of the model, closing the outer skin, and filling the skin to create a filled solid body. The method may also include deleting the model from which the surface extract was generated. The method may further include verifying that the internal design profiles were removed in response to deleting the model. The method may still further include generating a set of two-dimensional views of the model to filter internal components, each two-dimensional view from a respective viewpoint, where the set of viewpoints encircles the three-dimensional model. The set of two-dimensional views may depict solid lines and not depict hidden lines. The method may include determining a component of the three-dimensional model corresponding to a geometrical entity of each of the two dimensional views and filtering out components of the three-dimensional model for which no geometrical entity of any of the two-dimensional views was determined to correspond. The filtered components of the three-dimensional model may be visually differentiated from the unfiltered components of the three-dimensional model.

In another example embodiment, an apparatus for providing a simplified representation of a computer-aided design model is provided. The apparatus may include processing circuitry. The processing circuitry may be configured for determining cavities within a three-dimensional computer-aided design model and closing the cavities with a closing feature, where the closing feature is disposed at a pre-defined depth below the cavity opening. Determining cavities may include calculating the number of cavities within the model, where calculating the number of cavities may include checking the number of internal loops present on the model. The apparatus may further be configured to generate a surface extract including an outer skin of the model, close the outer skin, and fill the skin to create a filled solid body. The apparatus may further be configured to delete the model from which the surface extract was generated and verify that internal design profiles were removed in response to deleting the model. The apparatus may also be configured to generate a set of two-dimensional views of the model, each two-dimensional view from a respective viewpoint, where the set of viewpoints encircles the three-dimensional model. The apparatus may further be configured to determine a component of the three-dimensional model corresponding to a geometrical entity of each of the two-dimensional views and filter out components of the three-dimensional model for which no geometrical entity of any of the two-dimensional views was determined to correspond. The filtered components of the three-dimensional model may be visually differentiated from the unfiltered components of the three-dimensional model.

In another example embodiment, a computer program product for providing a simplified representation of a computer-aided design model is provided. The computer program product may include at least one computer-readable storage medium having computer-executable program code instructions stored therein. The computer-executable program code instructions may include program code instructions for determining cavities within a three-dimensional computer aided design model and program code instructions for closing the cavities with a closing feature, where the closing feature is disposed at a pre-defined depth below the cavity opening. The program code instructions for determining cavities may include program code instructions for calculating the number of cavities within the model, where the program code instructions for calculating the number of cavities includes program code instructions for checking the number of internal loops present on the model. The computer program product may further include program code instructions for generating a surface extract including an outer skin of the model, program code instructions for closing the outer skin, and program code instructions for filling the skin to create a filled solid body. The computer program product may further include program code instructions for deleting the model from which the surface extract was generated and program code instructions for verifying that the internal design profiles were removed in response to deleting the model. The computer program product may further include program code instructions for generating a set of two-dimensional views of the model, each two-dimensional view from a respective viewpoint, where the set of viewpoints encircles the three-dimensional model. The computer program product may further include program code instructions for determining a component of the three-dimensional model corresponding to a geometrical entity of each of the two-dimensional views and program code instructions for filtering out components of the three-dimensional model for which no geometrical entity of any of the two-dimensional views was determined to correspond. The filtered components of the three-dimensional model may be visually differentiated from the unfiltered components of the three-dimensional model.

### BRIEF DESCRIPTION OF THE SEVERAL VIEWS OF THE DRAWING(S)

Having thus described embodiments of the invention in general terms, reference will now be made to the accompanying drawings, which are not necessarily drawn to scale, and wherein:

FIG. 1 is an illustration of a three-dimensional computer-aided design model according to an example embodiment of the present invention;

FIG. 2 is an illustration of a simplified rendering of a three-dimensional computer-aided design model according to an example embodiment of the present invention;

FIG. 3 depicts a set of two-dimensional views taken from a three-dimensional computer-aided design model according to an example embodiment of the present invention;

FIG. 4 illustrates an example embodiment of a block diagram of an apparatus configured for implementing example embodiments of the present invention; and

FIG. 5 illustrates a flow chart of a method according to an example embodiment of the present invention.

### DETAILED DESCRIPTION

Embodiments of the present invention will now be described more fully hereinafter with reference to the accompanying drawings, in which some, but not all embodiments of the invention are shown. Indeed, embodiments of the invention may be embodied in many different forms and should not be construed as limited to the embodiments set forth herein; rather, these embodiments are provided so that this disclosure will satisfy applicable legal requirements. Like reference numerals refer to like elements throughout.

As indicated above, various approaches have been taken to convert a complex CAD model to a simplified representation of the CAD model; however, most approaches are time and labor intensive and require significant manual input from a user. While some solutions for providing simplified representation of CAD models have been previously proposed, each of these solutions has significant drawbacks. The requirement for a user to manually perform many of the operations in creating a simplified representation of a CAD model can be both time consuming and error prone. In some cases, if the user fails to remove components, proprietary information may be leaked to external sources. Additionally, if errors are made on external surfaces or components, a supplier or customer may inadvertently encounter or create issues with the design of a system or package that the component represented by the erroneous CAD model introduced.

A three-dimensional computer-aided design model may include high levels of detail and proprietary information about a product that would be detrimental to a company if shared; however, it is often necessary to share a low-level of detail with manufacturers, suppliers, or customers for them to be able to integrate the product into their systems. While agreements and contracts may be in place, reverse-engineering of a 3-D model is always a possibility and the higher the level of detail of the model, the easier reverse engineering may be. To protect a design, users may remove detail from a 3-D model without removing aspects of the model which are critical for a manufacturer, supplier, or customer to use.

A user implementing existing methods to convert a complex CAD model to a simplified representation of the CAD model may first convert the assembly into a simplified part in which each component of the assembly is converted to a solid lacking creation history. The user may then create thickened solids (a padded shape) to mask each outside cavity while keeping the cavity profile visible. A user may then visually locate all internal components individually and remove them from the assembly manually before finally grouping various components to result in a few major components. Cavities which are present on non-planar surfaces and those that have non-cylindrical profiles pose a greater challenge to the user such that expertise and experience are necessary to properly fill those cavities. Assemblies, such as turbochargers for internal combustion engines that contain hundreds of components may include 60-70% internal components requiring dozens or hundreds of individual components to be manually selected and deleted.

Some example embodiments of the present invention may define a set of flexible and accurate methods and procedures to close cavities, remove internal components, simplify the assembly and reduce the number of components in the 3-D model. Example embodiments of the methods presented herein may be used in any 3-D assembly.

Typically a 3-D assembly may contain links with different component models such that the assembly file does not actually include the component solids displayed therein, but rather links to files that are brought in to the assembly. In order to simplify the assembly, for example, closing the cavities, the designer may need to switch back and forth between linked component models and the assembly model. Such switching may add difficulty and complexity to the simplification process and may require a user to understand how the assembly is generated. Nested sub-assemblies may further complicate the process requiring a user to switch between various levels of component assemblies to get to an individual component 3-D model. Example embodiments of the present invention may use a simplified form of a 3-D assembly where all of the components are contained within a single level of the 3-D assembly model, such as a general 3-D model with many solid bodies but no positioning constraints.

Example embodiments of the present invention may implement a flexible and semi-automatic approach to close the cavities of the 3-D model. When closing the cavities of the 3-D model, it may be desirable to leave the outer profile of the cavity visible despite surrounding non-planar surfaces and non-cylindrical cavity profiles. Methods according to embodiments of the present invention may create a closing feature at a certain depth below the cavity opening. The depth below the cavity opening may be user-defined based on the application. The depth below the cavity opening, or offset, further ensures that non-standard cavities (i.e., non-cylindrical or cavities in non-planar surfaces) are fully closed by the offset closure. The number of cavities or openings in a 3-D model may be determined by checking the number of internal loops present on the 3-D model. When more than one loop is present, the user may be presented with the option of closing all of the openings or selecting specific openings or cavities which are to be closed. Once each of the cavities is closed, a quality check may be performed to verify that the closures have fully closed the cavities that were requested by the user to be closed.

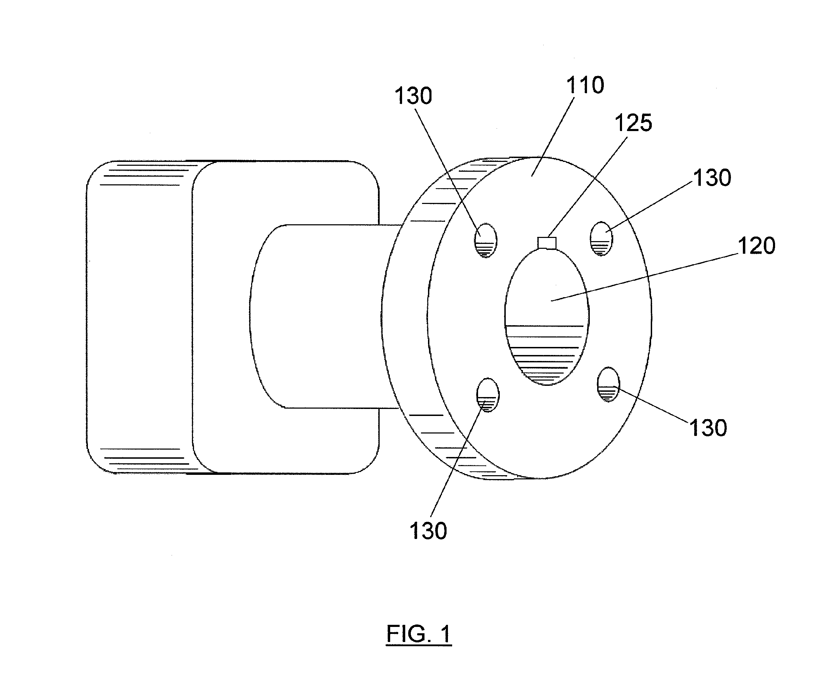

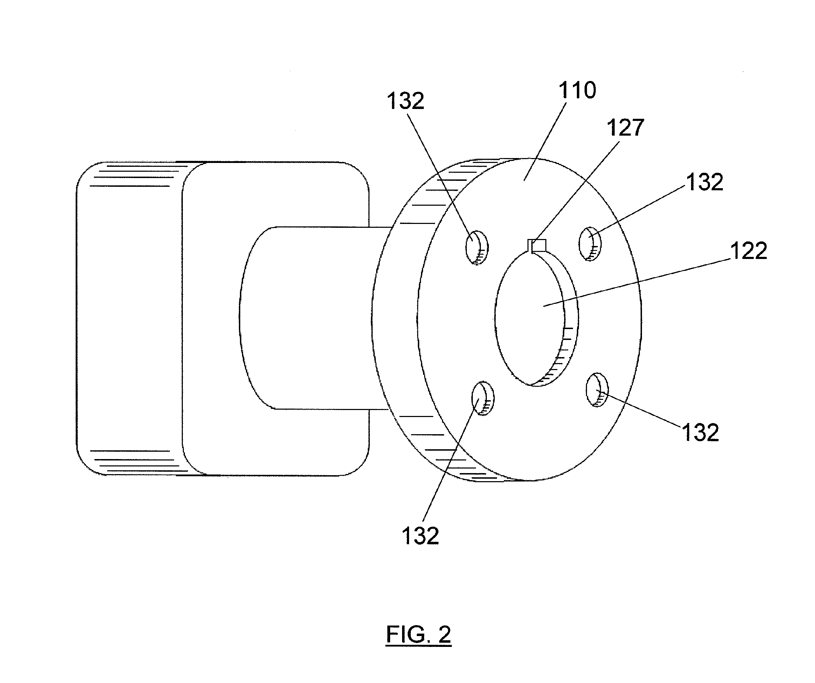

FIG. 1 illustrates an example embodiment of a 3-D solid model. In the illustrated embodiment, flange 110 includes a first cavity 120 that is substantially circular; however, the first cavity further includes a rectangular keyway 125 as part of the cavity. Flange 110 further includes fastener cavities 130. Methods according to embodiments of the present invention may analyze the 3-D solid model and determine that the illustrated embodiment of FIG. 1 includes five cavities (120, 130). The user may be given the option of closing one, some, or all of the cavities and the user may determine the depth or offset at which the cavities are to be closed. FIG. 2 illustrates each of the five cavities closed by closures (122, 132) or surfaces that are disposed at a depth equivalent to the offset determined by the user. The closures 122, 132 fully occupy the cavities which they are intended to close. Further, non-standard, non-circular cavity 120 has been closed by closure 122 which includes closure portion 127 which closes the keyway 125, thereby fully closing the cavity. While not illustrated, a cavity with a non-planar opening may benefit from a closure formed at a pre-defined depth as the contour around the opening may cause a closure formed at the opening to not fully close the cavity.

Embodiments of the present invention may further include a method to remove internal components from a 3-D model. The internal components are components that are not visible when viewing the outside of the 3-D model, except perhaps as seen through an opening or cavity which is to be closed. Internal components may be differentiated from the external components which are visible from an external view of the 3-D model by embodiments of the present invention. The internal components and external components may also be color-coded to facilitate easy differentiation when viewed by a user for purposes of verification or a quality check of software performance. Removing components from the 3-D model may comprise determining the external components and retaining them while deleting or otherwise removing the remaining components and sub-assemblies.

Some existing techniques for removing internal components of a 3-D model include virtually wrapping the 3-D model and creating a surface of the virtual wrap. The wrapping may be performed using a facet model which may be an efficient method computationally; however, the level of detail provided by the facet method is may be inadequate for highly-detailed models. The facet method using the polygonal model, specifically the "triangular mesh" representation is very efficient to be rendered in graphics software, but is often inadequate for accurate shape modeling. The wrapping may be performed using the boundary representation (B-rep) method with curved surface equations used to describe the shape of the model; however, the B-rep method may be computationally intensive and inefficient when rendering the graphics. The challenges of both the facet method and the B-rep method become greater when complex shapes, such as variable radius fillets, chamfers, and cut-outs are involved.

Another method for determining internal components versus external components may include collision detection algorithms. Collision detection algorithms check the interferences between complex objects and make comparisons between all pairs of simple parts of the objects. However, when complex shapes are involved or a large number of parts are involved, each of the parts must be checked against one another resulting in a large computational load for the determination of the interferences.

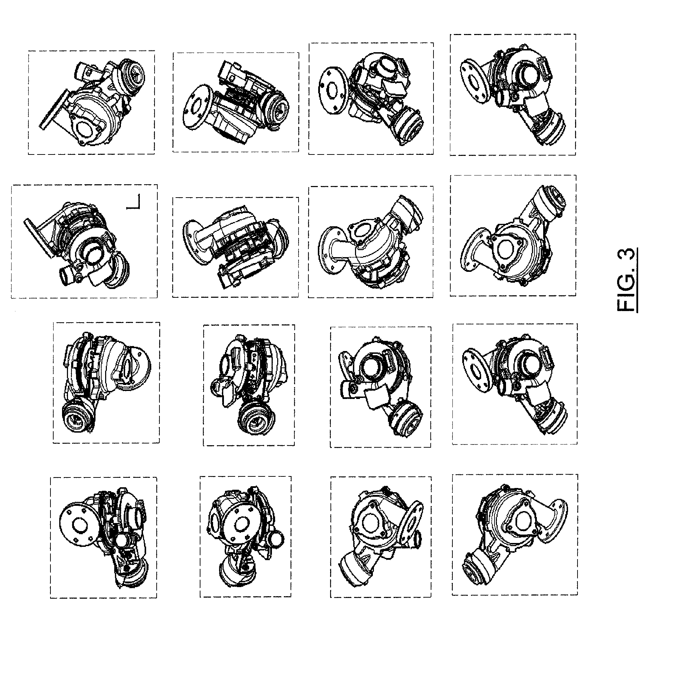

Example embodiments of the present invention may provide an improved method of determining internal components versus external components in a computationally efficient and highly-detailed manner. The method may produce a set of two-dimensional (2-D) images created from the 3-D model. Each of the 2-D images may be generated by a viewpoint of the 3-D model. Each different 2-D image may then be generated by rotating the viewpoint a certain measure, such as 45 degrees as measured from a center-point of the 3-D model, from a previous viewpoint. The series of viewpoints or set of viewpoints used to create the set of 2-D images may substantially encircle the 3-D model. FIG. 3 illustrates an example embodiment of sixteen views of a 3-D model, each taken from a different viewpoint around the model. The 2-D images may be generated to illustrate only the solid lines from the model and not the hidden lines indicative of an object or line not visible from the viewpoint outside of the 3-D solid model. However, in some embodiments, the 2-D images may also be configured to generate views that include a broken lines that are indicative of a hidden feature. Each 2-D image created may consist of a set of geometrical entities such as lines, arcs, circles, and splines corresponding to components in the 3-D assembly model. From the view geometries, embodiments of the present invention may determine the link between the 2-D generated geometries of drawing with the respective component in the 3-D model. For components in the 3-D model which are not visible from outside of the model, no geometrical entities would be generated in the 2-D views such that the component can be filtered out as an internal component. For components in the 3-D model which are represented in the 2-D views only in broken line form indicative of a hidden line, those components may be filtered out. The 2-D views generated during this process may be temporary and may be deleted after the process is complete.

According to example embodiments of the present invention, using the above outlined approach of generating 2-D views, the internal and external components may be differentiated to provide the user a graphical user interface illustrating the internal versus external components and provide the user with a list of each. Further, embodiments may set the color of all external components to a first color and internal components to a second color, different than the first color, to provide quick and easy visual differentiation by the user. In addition to or in lieu of color differentiation, embodiments may hide or show internal or external components or vary the transparency of one or both of the sets of components. Optionally, the internal components may be visually differentiated from the components that include an external surface by depicting the internal components in broken line form. Such component differentiation allows a user to perform a visual verification or quality check of the automated method for filtering internal and external components.

Upon removing or deleting the internal components which could be proprietary in nature or contain proprietary information, embodiments of the present invention may simplify the external components by reducing the number of components to a more reasonable and manageable amount. For example, a turbocharger may be reduced to four major components including a turbine housing, a compressor housing, center assembly, and actuator. Reducing the number of external components by combining groups of smaller components into larger components facilitates the translation process to simplify the representation of the 3-D model. The translation of a 3-D model from a source system to a target system is not always smooth and if the number of bodies or components to be translated is higher, the translation may encounter further issues.

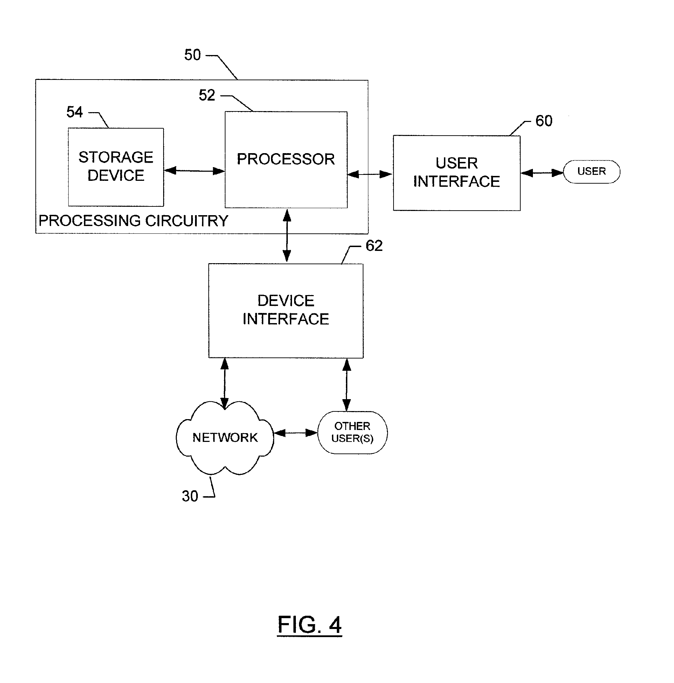

An example embodiment of the invention will now be described with reference to FIG. 4. FIG. 4 shows certain elements of an apparatus for provision of creating or rendering a CAD model or a simplified CAD model according to an example embodiment. The apparatus of FIG. 4 may be employed, for example, on a client (e.g., any of the clients of a network) or a variety of other devices (such as, for example, a network device, server, proxy, or the like (e.g., an application server). Alternatively, embodiments may be employed on a combination of devices. Accordingly, some embodiments of the present invention may be embodied wholly at a single device (e.g., the application server or one or more clients) or by devices in a client/server relationship (e.g., the application server and one or more clients). Furthermore, it should be noted that the devices or elements described below may not be mandatory and thus some may be omitted in certain embodiments.

Each one of the above mentioned clients may be, for example, a computer (e.g., a personal computer, laptop computer, network access terminal, or the like) or may be another form of computing device (e.g., a personal digital assistant (PDA), cellular phone, smart phone, or the like) capable of communication with a network or performing at least a portion of the functionality required to generate or render a CAD model or convert a CAD model to a simplified CAD model. As such, for example, each one of the clients may include (or otherwise have access to) memory for storing instructions or applications for the performance of various functions and a corresponding processor for executing stored instructions or applications. Each one of the clients may also include software and/or corresponding hardware for enabling the performance of the respective functions of the clients as described below. In an example embodiment, one or more of the clients may include a client application configured to operate in accordance with an example embodiment of the present invention. In this regard, for example, the client application may include software for enabling a respective one of the clients to communicate with a network for requesting and/or receiving a CAD model or CAD drafting/rendering application in the form of a deliverable component (e.g., as downloadable software to configure the client, or as a transferable memory device including instructions to configure the client). As such, for example, the client application may include corresponding executable instructions for configuring the client to provide corresponding functionalities for providing a simplified representation of a 3-D model.

Referring again to FIG. 4, an apparatus for provision of simplifying a representation of a CAD model is provided. The apparatus may include or otherwise be in communication with processing circuitry 50 that is configured to perform data processing, application execution and other processing and management services according to an example embodiment of the present invention. In one embodiment, the processing circuitry 50 may include a processor 52 and a storage device 54 that may be in communication with or otherwise control a user interface 60 and a device interface 62. As such, the processing circuitry 50 may be embodied as a circuit chip (e.g., an integrated circuit chip) configured (e.g., with hardware, software or a combination of hardware and software) to perform operations described herein. However, in some embodiments, the processing circuitry 50 may be embodied as a portion of a server, computer, laptop, workstation or even one of various mobile computing devices. In situations where the processing circuitry 50 is embodied as a server or at a remotely located computing device, the user interface 60 may be disposed at another device (e.g., at a computer terminal or client device such as one of the clients) that may be in communication with the processing circuitry 50 via the device interface 62 and/or a network (e.g., network 30).

The user interface 60 may be in communication with the processing circuitry 50 to receive an indication of a user input at the user interface 60 and/or to provide an audible, visual, mechanical or other output to the user. As such, the user interface 60 may include, for example, a keyboard, a mouse, a joystick, a display, a touch screen, a microphone, a speaker, a cell phone, or other input/output mechanisms. In embodiments where the apparatus is embodied at a server or other network entity, the user interface 60 may be limited or even eliminated in some cases.

The device interface 62 may include one or more interface mechanisms for enabling communication with other devices and/or networks. In some cases, the device interface 62 may be any means such as a device or circuitry embodied in either hardware, software, or a combination of hardware and software that is configured to receive and/or transmit data from/to a network and/or any other device or module in communication with the processing circuitry 50. In this regard, the device interface 62 may include, for example, an antenna (or multiple antennas) and supporting hardware and/or software for enabling communications with a wireless communication network and/or a communication modem or other hardware/software for supporting communication via cable, digital subscriber line (DSL), universal serial bus (USB), Ethernet or other methods. In situations where the device interface 62 communicates with a network, the network may be any of various examples of wireless or wired communication networks such as, for example, data networks like a Local Area Network (LAN), a Metropolitan Area Network (MAN), and/or a Wide Area Network (WAN), such as the Internet.

In an example embodiment, the storage device 54 may include one or more non-transitory storage or memory devices such as, for example, volatile and/or non-volatile memory that may be either fixed or removable. The storage device 54 may be configured to store information, data, applications, instructions or the like for enabling the apparatus to carry out various functions in accordance with example embodiments of the present invention. For example, the storage device 54 could be configured to buffer input data for processing by the processor 52. Additionally or alternatively, the storage device 54 could be configured to store instructions for execution by the processor 52. As yet another alternative, the storage device 54 may include one of a plurality of databases that may store a variety of files, contents or data sets. Among the contents of the storage device 54, applications (e.g., client application or service application such as the CAD software program) may be stored for execution by the processor 52 in order to carry out the functionality associated with each respective application.

The processor 52 may be embodied in a number of different ways. For example, the processor 52 may be embodied as various processing means such as a microprocessor or other processing element, a coprocessor, a controller or various other computing or processing devices including integrated circuits such as, for example, an ASIC (application specific integrated circuit), an FPGA (field programmable gate array), a hardware accelerator, or the like. In an example embodiment, the processor 52 may be configured to execute instructions stored in the storage device 54 or otherwise accessible to the processor 52. As such, whether configured by hardware or software methods, or by a combination thereof, the processor 52 may represent an entity (e.g., physically embodied in circuitry) capable of performing operations according to embodiments of the present invention while configured accordingly. Thus, for example, when the processor 52 is embodied as an ASIC, FPGA or the like, the processor 52 may be specifically configured hardware for conducting the operations described herein. Alternatively, as another example, when the processor 52 is embodied as an executor of software instructions, the instructions may specifically configure the processor 52 to perform the operations described herein.

For a conventional simplified rendering of a CAD model, the user would typically be required to manually simplify the model as was described above with regard to existing techniques. This could be a time consuming and difficult task. Accordingly, embodiments of the present invention may enable users to automate at least a portion of the process for creating a simplified rendering of a 3-D CAD model. In this regard, the processor 52 or processing circuitry 50 may be configured to execute software or instructions to automatically, or at least partially automatically (i.e., requiring less user input than existing methods) create a simplified representation of the 3-D CAD model and provide information about the automatically generated representation to enable relatively easy viewing of the simplified representation at a later time.

The processor 52 may be configured to determine the cavities within a 3-D CAD model and provide a user with the option of filling or closing one or more of the cavities found within the model. The processor 52 may determine the number of cavities or openings on a surface by determining the number of internal loops present on the surface. The processor 52 may then provide for filling the cavities at a pre-defined (or user-defined) depth below the surface.

The processor 52 or processing circuitry 50 may be configured to generate a set of two-dimensional (2-D) images. The images generated may each be generated by a different viewpoint of the 3-D model such that each viewpoint is, for example, 45 degrees away from a previous viewpoint as measured from a center-point of the 3-D model. The set of viewpoints may substantially encircle the 3-D model. The storage device 54 may store the images generated to enable embodiments of the present invention to determine the component of the 3-D model that corresponds to one or more of the geometric entities of each of the 2-D images. The geometric entities may be lines, arcs, circles, splines, or the like. From the various viewpoint geometries, the processor 52 may determine a link between the 2-D geometries and the components of the 3-D model. Components that are not visible in the 2-D geometries may be determined, by the processor 52, to be internal components and may therefore be removed from the simplified representation of the 3-D model.

In response to a component not visible in the 2-D geometries, embodiments of the present invention may shade the components in a color different than components that are visible in the 2-D geometries. In this regard, FIG. 3 depicts the 2-D views created by the software or instructions as executed by the processor 52 for storage by the storage device 54. The 2-D images may be deleted or removed from the storage device 54 when the simplification process is complete. Further, the processing circuitry 50 or processor 52 may be configured to combine remaining components of the 3-D model into larger components to reduce the overall number of components in the simplified representation of the 3-D model.

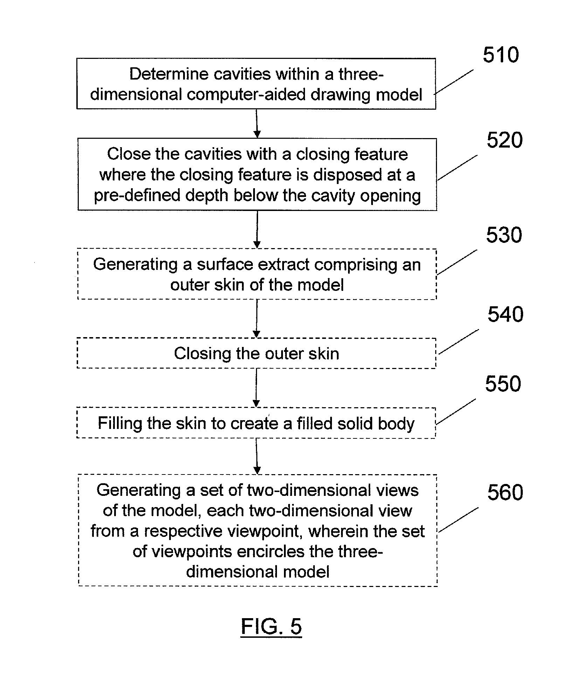

Embodiments of the present invention may therefore be practiced using an apparatus such as the one depicted in FIG. 4. However, other embodiments may be practiced in connection with a computer program product for performing embodiments of the present invention. FIG. 5 is a flowchart of a method and program product according to example embodiments of the invention. Each block or step of the flowchart of FIG. 5, and combinations of blocks in the flowchart, may be implemented by various means, such as hardware, firmware, processor, circuitry and/or another device associated with execution of software including one or more computer program instructions. Thus, for example, one or more of the procedures described above may be embodied by computer program instructions, which may embody the procedures described above and may be stored by a storage device (e.g., storage device 54) and executed by processing circuitry (e.g., processor 52).

As will be appreciated, any such stored computer program instructions may be loaded onto a computer or other programmable apparatus (i.e., hardware) to produce a machine, such that the instructions which execute on the computer or other programmable apparatus implement the functions specified in the flowchart block(s). These computer program instructions may also be stored in a non-transitory computer-readable storage medium comprising memory that may direct a computer or other programmable apparatus to function in a particular manner, such that the instructions stored in the computer-readable memory produce an article of manufacture including instructions to implement the function specified in the flowchart block(s). The computer program instructions may also be loaded onto a computer or other programmable apparatus to cause a series of operations to be performed on the computer or other programmable apparatus to produce a computer-implemented process such that the instructions which execute on the computer or other programmable apparatus provide operations for implementing the functions specified in the flowchart block(s).

In this regard, a method according to one embodiment of the invention, as shown in FIG. 5, may include determining cavities within a three-dimensional computer aided design model at 510 and closing the cavities with a closing feature, where the closing feature is disposed at a pre-defined depth below the cavity opening at 520.

In some cases, the method may include additional optional operations (some examples of which are shown in dashed lines in FIG. 5). Any additional operations, and/or modifications to the operations above or the additional operations, may be performed in addition to the operations described above in any order and in any combination. Thus, in some embodiments, all of the additional operations or modifications may be practiced, while in others none of the additional operations or modifications may be practiced. In still other embodiments, any combination of less than all of the additional operations or modifications may be practiced. In an example embodiment, the method may further include generating a surface extract comprising an outer skin of the model at 530, closing the outer skin at 540, and filling the skin to create a filled solid body at 550. An additional operation that may be performed includes generating a set of two-dimensional views of the model, each two-dimensional view from a respective viewpoint, where the set of viewpoints encircles the three-dimensional model as shown at 560.

Many modifications and other embodiments of the inventions set forth herein will come to mind to one skilled in the art to which these inventions pertain having the benefit of the teachings presented in the foregoing descriptions and the associated drawings. Therefore, it is to be understood that the inventions are not to be limited to the specific embodiments disclosed and that modifications and other embodiments are intended to be included within the scope of the appended claims. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

## Claims

1. A method comprising:
determining cavities within a three-dimensional computer aided design model; and
closing the cavities with a closing feature, wherein the closing feature is disposed at a pre-defined depth below the cavity opening.

2. The method of Claim 1, wherein the determining cavities comprises calculating the number of cavities within the model.

3. The method of Claim 2, wherein calculating the number of cavities comprises checking the number of internal loops present on the model.

4. The method of Claim 1, further comprising:
generating a surface extract comprising an outer skin of the model;
closing the outer skin; and
filling the skin to create a filled solid body.

5. The method of Claim 4, further comprising deleting the model from which the surface extract was generated.

6. The method of Claim 5, further comprising verifying that internal design profiles were removed in response to deleting the model.

7. The method of Claim 1, further comprising:
generating a set of two-dimensional views of the model, each two-dimensional view from a respective viewpoint, wherein the set of viewpoints encircles the three-dimensional model.

8. The method of Claim 7, wherein the set of two-dimensional views depicts solid lines and does not depict hidden lines.

9. The method of Claim 7, further comprising determining a component of the three-dimensional model corresponding to a geometrical entity of each of the two-dimensional views.

10. The method of Claim 9, further comprising filtering out components of the three-dimensional model for which no geometrical entity of any of the two-dimensional views was determined to correspond.

11. The method of Claim 10, wherein the filtered components of the three-dimensional model are visually differentiated from the unfiltered components of the three-dimensional model not filtered.

12. A computer program product comprising at least one computer-readable storage medium having computer-executable program code instructions stored therein, the computer-executable program code instructions comprising:
program code instructions for determining cavities within a three-dimensional computer aided design model; and
program code instructions for closing the cavities with a closing feature, wherein the closing feature is disposed at a pre-defined depth below the cavity opening.

13. The computer program product of Claim 12, wherein the program code instructions for determining cavities comprises program code instructions for calculating the number of cavities within the model, wherein the program code instructions for calculating the number of cavities comprises program code instructions for checking the number of internal loops present on the model.

14. The computer program product of Claim 12, further comprising:
program code instructions for generating a surface extract comprising an outer skin of the model;
program code instructions for closing the outer skin; and
program code instructions for filling the skin to create a filled solid body.

15. The computer program product of Claim 14, further comprising program code instructions for deleting the model from which the surface extract was generated.

16. The computer program product of Claim 15, further comprising program code instructions for verifying that internal design profiles were removed in response to deleting the model.

17. The computer program product of Claim 12, further comprising:
program code instructions for generating a set of two-dimensional views of the model, each two-dimensional view from a respective viewpoint, wherein the set of viewpoints encircles the three-dimensional model.

18. The computer program product of Claim 17, further comprising:
program code instructions for determining a component of the three-dimensional model corresponding to a geometrical entity of each of the two-dimensional views; and
program code instructions for filtering out components of the three-dimensional model for which no geometrical entity of any of the two-dimensional views was determined to correspond.

19. The computer program product of Claim 18, wherein the filtered components of the three-dimensional model are visually differentiated from the unfiltered components of the three-dimensional model.
